(19) Europäisches Patentamt
European Patent Office
Office européen des brevets

(11) **EP 4 538 722 B1**

(12) **EUROPEAN PATENT SPECIFICATION**

(45) Date of publication and mention
of the grant of the patent:
**18.02.2026 Bulletin 2026/08**

(21) Application number: **24205147.2**

(22) Date of filing: **08.10.2024**

(51) International Patent Classification (IPC):
**G01R 29/24** (2006.01)  **H10N 60/12** (2023.01)
**H10N 60/10** (2023.01)  **G06N 10/40** (2022.01)

(52) Cooperative Patent Classification (CPC):
**G01R 29/24; H10N 60/12; H10N 60/128;**
**G06N 10/40**

(54) **JOSEPHSON JUNCTION-BASED CHARGE SENSING IN QUANTUM SYSTEMS**

JOSEPHSON-ÜBERGANGSBASIERTE LADUNGSMESSUNG IN QUANTENSYSTEMEN

DÉTECTION DE CHARGE BASÉE SUR UNE JONCTION JOSEPHSON DANS DES SYSTÈMES QUANTIQUES

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **12.10.2023 US 202318486080**

(43) Date of publication of application:
**16.04.2025 Bulletin 2025/16**

(73) Proprietor: **The Boeing Company**
**Arlington, VA 22202 (US)**

(72) Inventors:
• **MAGYAR, Rudolph J.**
**Arlington, 22202 (US)**
• **DAYTON, Ian M.**
**Arlington, 22202 (US)**
• **SHEA, Colin W.**
**Arlington, 22202 (US)**

(74) Representative: **Arnold & Siedsma**
**Bezuidenhoutseweg 57**
**2594 AC The Hague (NL)**

(56) References cited:
**JP-A- 2008 076 082    US-A1- 2003 173 498**

• **ZORIN A. B.: "Quantum-Limited Electrometer Based on Single Cooper Pair Tunneling", vol. 76, no. 23, 1 June 1996 (1996-06-01), US, pages 4408 - 4411, XP093250043, ISSN: 0031-9007, Retrieved from the Internet <URL:https://journals.aps.org/ prl/pdf/10.1103/PhysRevLett.76.4408> DOI: 10.1103/PhysRevLett.76.4408**
• **LOTKHOV S V ET AL: "Superconducting electrometer based on the resistively shunted Bloch transistor", IEEE TRANSACTIONS ON APPLIED SUPERCONDUCTIVITY, IEEE, USA, vol. 9, no. 2, 1 June 1999 (1999-06-01), pages 3664 - 3667, XP011502107, ISSN: 1051-8223, DOI: 10.1109/77.783823**

**Description**

FIELD

Aspects of the present disclosure relate to techniques for localized charge sensing within quantum systems.

BACKGROUND

Obtaining high-speed, accurate measurements of localized charge state of a quantum system is challenging. Existing solutions for measuring localized charge include capacitively coupling to a tunnel dot (or "measure island") and operating as a conventional field-effect transistor (FET). The amount of current flowing through the source and drain terminals of the FET will change as the charge occupancy in the bias on the measure island varies. However, to acquire accurate measurements of the charge occupancy of the coupled islands, multiple samples of the measure island current response are required. The method is relatively slow, typically requiring on the order of microseconds to perform an integration function, and also requires highly sensitive amplification on the output, as well as resistors near the measure island that tend to cause local heating and noise generation.

In the paper titled "Quantum-Limited Electrometer Based on Single Cooper Pair Tunneling", in Physical Review Letters, vol. 76, no. 23, of June 1, 1996, on pages 4408-4411, Zorin A.B. states, according to the abstract, a system comprising the small-capacitance double Josephson junction shunted as a whole by a small resistance. Zorin calculated the dynamic and noise characteristics of the system as function of a polarization charge on the central electrode. The energy resolution of such an electrometer implying the "backaction noise" is said to approach the fundamental quantum limit h/2 when T→0. The system comprises a single Cooper pair tunneling transistor (SCPT) having an equivalent circuit wherein two small-capacitance Josephson Junctions form inside a small superconducting island. A signal source is coupled to the island via a small capacitance. A current source provides a bias current to the SCPT. A charge-to-voltage response function is discussed.

US 2003/173498 A1, according to its abstract, states a method for reading out the state of a mesoscopic phase device. In the method the mesoscopic phase device is coherently coupled to a mesoscopic charge device using a phase shift device and the quantum state of the mesoscopic charge device is measured. A method for reading out the quantum state of a qubit in a heterogeneous quantum register. The heterogeneous quantum register includes a first plurality of phase qubits and a second plurality of charge qubits. In the method a first phase qubit or a first charge qubit in the heterogeneous quantum register is selected. The first phase qubit or the first charge qubit is coherently connected to a mesoscopic charge device for a duration. The quantum state of the mesoscopic charge device is read out after the duration has elapsed. An exemplary method for performing a read out operation on a qubit is disclosed, which method comprises applying a bias current across the leads of a superconducting single-electron transistor (SSET), wherein the mesoscopic island of the SSET is coherently coupled to a phase qubit, and measuring the resulting voltage across the leads of the SSET. The bias current Ib can be chosen to be between the critical currents of the mesoscopic island of the SSET device as correlated with the basis states of the phase qubit, such that Ib will exceed the critical current if the phase qubit occupies a first basis state, thus driving the SSET into the dynamical regime and causing a voltage drop across the SSET leads, whereas if the phase qubit occupies a second basis state, then Ib will not exceed the critical current of the SSET and no voltage will be measured across the leads.

In the paper titled "Superconducting electrometer based on the resistively shunted Bloch transistor" in IEEE Transactions on Applied Superconductivity, vol. 9, no. 2, of June 1, 1999, on pages 3664-3667, Lotkhov S.V. et al. state, according to the abstract, that they fabricated the Bloch transistor shunted on-chip by a small-sized Cr resistor with $R_s$ of about 1 kilo-Ohm. The Bloch transistor is said to normally consist of two small Josephson junctions connected in series, which in their case have been replaced by two superconducting interferometer loops, each said to have two junctions in parallel. A capacitively coupled gate is said to have been supplied to control the induced charge of the small intermediate electrode (island) of the transistor. The measured I-V curves are said to have shown no hysteresis and correspond to the operation of an effective Josephson junction at the high-damping and strong-noise limits. The critical current of the system is said to have been found to be close to its nominal value, which is said to be in accordance with the electromagnetic environment theory. The I-V curves are said to have been modulated by the gate with a period of e and a maximum swing of about 2 microvolt. Such rather moderate modulation results from the Josephson-to-charging energies ratio, $E_J/E_C$ of about 9, in their sample said to have been far from its optimum value.

JP 2008 076082 A, according to its abstract, states a detection element comprising a silicon membrane provided with a cantilever beam, a superconducting closed circuit formed in a surface or the inside of the cantilever beam, a Josephson junction inserted in the closed circuit, and a property change detection means for detecting deformation of the cantilever beam on the basis of changes in a maximum superconducting current which can be made to flow through the superconducting closed circuit. The property change detection means is provided with a means for applying magnetic fields to the closed circuit, a means for applying a bias current to the closed circuit, and a means for detecting a voltage generated in the closed circuit.

SUMMARY

The present disclosure provides a method of charge sensing in a quantum system according to independent claim 1. In one aspect, the method includes supplying a bias current through a Josephson junction, the bias current less than a first value of a critical current of the Josephson junction. The method further includes measuring an output voltage of the Josephson junction. Responsive to a change in charge of one or more charge islands coupled to the Josephson junction, the critical current is reduced to a second value less than the bias current, causing a voltage drop across the Josephson junction.

In one aspect, in combination with any example method above or below, each of the one or more charge islands includes a respective one or more quantum dots, one or more material defects, one or more grain boundaries, or one or more micro surface features.

In the claimed invention, the one or more charge islands include a plurality of charge islands each coupled to the Josephson junction through a respective capacitor.

In the claimed invention, some or all of the capacitors, corresponding to the plurality of charge islands, have different capacitance values.

In one aspect, in combination with any example method above or below, the method further includes updating, using a shunt resistor coupled across the Josephson junction, the critical current of the Josephson junction to a second value responsive to the change in charge of the one or more charge islands.

In one aspect, in combination with any example method above or below, the Josephson junction is included in a Josephson junction field-effect transistor (JJFET), the one or more charge islands are capacitively coupled to a gate of the JJFET, and the bias current is supplied by a current source coupled to a source or drain of the JJFET.

In one aspect, in combination with any example method above or below, the Josephson junction is included in a pair of series-connected Josephson junctions, the one or more charge islands are capacitively coupled between the Josephson junctions of the pair, and the bias current is supplied by a current source coupled with one of the Josephson junctions of the pair.

The present disclosure provides an apparatus according to independent claim 6. In one aspect, the apparatus includes a Josephson junction field-effect transistor (JJFET), one or more charge islands capacitively coupled to a gate of the JJFET, and a current source coupled with one of a source or a drain of the JJFET. The current source is to supply a bias current less than a first value of a critical current of the JJFET, and a predefined change in charge to the one of more charge islands reduces the critical current to a second value less than the bias current.

In one aspect, in combination with any example apparatus above or below, each of the one or more charge islands includes a respective one or more quantum dots, one or more material defects, one or more grain boundaries, or one or more micro surface features.

In the claimed invention, the one or more charge islands includes a plurality of charge islands each coupled to the gate through a respective capacitor.

In the claimed invention, some or all of the capacitors, corresponding to the plurality of charge islands, have different capacitance values.

In one aspect, in combination with any example apparatus above or below, the apparatus further includes a shunt resistor coupled between the source and the drain of the JJFET.

In one aspect, in combination with any example apparatus above or below, the apparatus further includes measurement circuitry coupled to the other of the source or the drain of the JJFET.

In one aspect, in combination with any example apparatus above or below, the measurement circuitry includes amplifier circuitry to amplify an output voltage of the JJFET.

The present disclosure provides an apparatus according to independent claim 11. In one aspect, the apparatus includes a pair of series-connected Josephson junctions, one or more charge islands capacitively coupled to a node between the Josephson junctions of the pair, and a current source coupled to a first Josephson junction of the pair. The current source is to supply a bias current less than a first value of an effective critical current of the Josephson junctions, and a predefined change in charge to the one of more charge islands reduces the effective critical current to a second value less than the bias current.

In one aspect, in combination with any example apparatus above or below, each of the one or more charge islands includes a respective one or more quantum dots, one or more material defects, one or more grain boundaries, or one or more micro surface features.

In the claimed invention, the one or more charge islands includes a plurality of charge islands each coupled between the Josephson junctions of the pair through a respective capacitor.

In the claimed invention, some or all of the capacitors, corresponding to the plurality of charge islands, have different capacitance values.

In one aspect, in combination with any example apparatus above or below, the apparatus further includes a shunt resistor coupled across the pair of Josephson junctions.

In one aspect, in combination with any example apparatus above or below, the apparatus further includes measurement circuitry coupled to a second Josephson junction of the pair.

BRIEF DESCRIPTION OF THE DRAWINGS

So that the manner in which the above recited features can be understood in detail, a more particular description, briefly summarized above, may be had by reference to example aspects, some of which are illustrated in the appended drawings.

Figure 1 depicts a perspective view of an exemplary Josephson junction, according to one or more aspects.

Figure 2 depicts a cross-sectional view of an exemplary Josephson junction field-effect transistor (JJFET), according to one or more aspects.

Figure 3 depicts a system having one or more charge sensors in a quantum-scale device or system according to one or more aspects.

Figure 4 depicts an exemplary apparatus having one or more charge islands capacitively coupled to a JJFET, according to one or more aspects.

Figure 5 depicts an exemplary apparatus having one or more charge islands capacitively coupled to a node between a pair of series-connected Josephson junctions, according to one or more aspects.

Figure 6 depicts plots of current-voltage (I-V) characteristics of a Josephson junction for different charge states, according to one or more aspects.

Figure 7 is a method of charge sensing in a quantum system, according to one or more aspects.

DETAILED DESCRIPTION

In the current disclosure, reference is made to various aspects. However, it should be understood that the present disclosure is not limited to specific described aspects. Instead, any combination of the following features and elements, whether related to different aspects or not, is contemplated to implement and practice the teachings provided herein. Additionally, when elements of the aspects are described in the form of "at least one of A and B," it will be understood that aspects including element A exclusively, including element B exclusively, and including element A and B are each contemplated. Furthermore, although some aspects may achieve advantages over other possible solutions and/or over the prior art, whether or not a particular advantage is achieved by a given aspect is not limiting of the present disclosure. Thus, the aspects, features, aspects and advantages disclosed herein are merely illustrative and are not considered elements or limitations of the appended claims except where explicitly recited in a claim(s). Likewise, reference to "the invention" shall not be construed as a generalization of any inventive subject matter disclosed herein and shall not be considered to be an element or limitation of the appended claims except where explicitly recited in a claim(s).

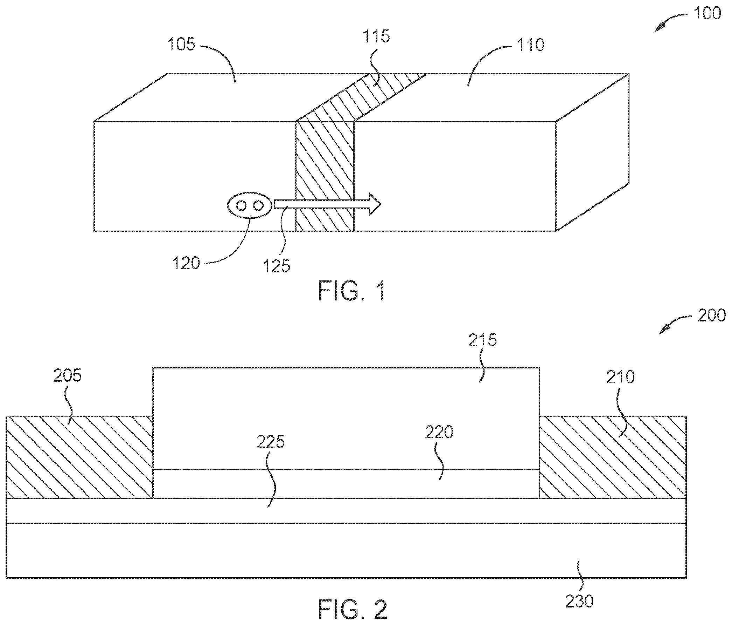

Figure 1 depicts a perspective view of an exemplary Josephson junction (JJ) 100, according to one or more aspects. The JJ 100 may be used in conjunction with any other aspects described herein. Further, in some aspects, the JJ 100 may be incorporated into a charge sensor and integrated into a quantum system.

The JJ 100 comprises a first superconductor section 105 spaced apart from a second superconductor section 110 by a weak link section 115. The first superconductor section 105 and the second superconductor section 110 may be formed of any suitable superconducting material(s). In some aspects, the weak link section 115 comprises an insulating material, such that the JJ 100 is implemented as a superconductor-insulator-superconductor (S-I-S) junction. In other aspects, the weak link section 115 comprises a non-superconducting metal material, such that the JJ 100 is implemented as a superconductor-non-superconducting metal-superconductor (S-N-S) junction. In yet other aspects, the weak link section 115 comprises a physical constriction providing areas of reduced superconductivity, such that the JJ 100 is implemented as a superconductor-constriction-superconductor (S-c-S) junction.

The weak link section 115 has suitable dimensioning to support the quantum tunneling of electrons therethrough. Typically, the thickness of the weak link section 115 may be on the order of 30 angstroms (Å) or less for an S-I-S junction, or on the order of several microns for a S-N-S junction. Although the components of the JJ 100 are shown in a linear arrangement for simplicity, other configurations and geometries of the JJ 100 are also contemplated.

The first superconductor section 105 and the second superconductor section 110, when cooled to cryogenic temperatures, are able to conduct electricity without providing any electrical resistance. The flow of a supercurrent 125, conducted through the JJ 100 across the weak link section 115, is governed by quantum tunneling of Cooper pairs 120 (that is, pairs of electrons having opposite spins that are bound together at cryogenic temperatures).

According to various aspects, and as will be discussed in greater detail below, the characteristics of the JJ 100 may be dynamically controlled to support fast, single-shot charge sensing by the JJ 100. For example, applying different values of electrostatic potential near the JJ 100 alters its quantum tunneling characteristics and thus an amount of the supercurrent 125. A "critical current" of the JJ 100 represents a maximum value of the supercurrent 125 that can flow through the JJ 100. When the current through the JJ 100 exceeds the critical current, the JJ 100 transitions from its superconducting state to a "normal" conducting state (that is, having resistive losses through the JJ 100). As a result, the voltage drop across the JJ 100 increases. In some aspects, the critical current of the JJ 100 is modulated using electrostatic potential(s) (e.g., altering the number of Cooper pairs 120 available for transport) such that a predefined change in charge that is "sensed" by the JJ 100 causes the JJ 100 to transition between the superconducting state and the conducting state. The resulting pulse in the output voltage of the JJ 100 may then be measured and/or conditioned to provide a signal indicative of the change in charge.

Figure 2 depicts a cross-sectional view of an exemplary JJ field-effect transistor (JJFET) 200, according to one or more aspects. The JJFET 200 may be used in conjunction with any other aspects described herein. Further, in some aspects, the JJFET 200 may be incorporated into a charge sensor and integrated into a quantum system.

The JJFET 200 comprises a source 205 and a drain 210 that are formed of any suitable superconductor material(s). The JJFET 200 further comprises a gate 215 disposed on an oxide layer 220. In some aspects, the gate 215 is formed of a metal material. The oxide layer 220 is disposed between the source 205 and the drain 210, and the gate 215 is disposed partly between the source 205 and the drain 210 (as shown, the gate 215 extends through the plane of the top surfaces of the source 205 and the drain 210). The source 205, the drain 210, and the oxide layer 220 are disposed on a channel layer 225 formed of a semiconductor material, and the channel layer 225 is disposed on a substrate 230 formed of an insulating material. The arrangement of the source 205, the drain 210, the gate 215, and the channel layer 225 supports a channel length that is sufficiently short to allow coherent transport of Cooper pairs through the channel. In this way, the JJFET 200 defines a first JJ with the channel layer 225 as its weak link section. The JJFET 200 may further define a second JJ with the gate 215 as its weak link section (e.g., a S-N-S junction), and/or a third JJ with the oxide layer 220 as its weak link section (e.g., a S-I-S junction). Although the components of the JJFET 200 are shown in a particular arrangement in Figure 2 for simplicity, other configurations and geometries of the JJFET 200 are also contemplated. For example, more complex geometries of the JJFET 200 may be effective to minimize or eliminate the second JJ and/or third JJ.

In a conventional FET, the flow of current between the source 205 and the drain 210 (i.e., through a channel formed in the channel layer 225) is controlled by the amount of voltage applied to the gate 215. The electric field established by the applied voltage modulates the conductivity of the channel layer 225. In the JJFET 200, the applied voltage alters the quantum tunneling characteristics of the one or more JJs of the JJFET 200. In some aspects, the critical current of the JJFET 200 is modulated using the applied voltage to the gate 215 (e.g., altering the number of Cooper pairs 120 that are available for transport in the supercurrent). In this way, a predefined change in charge that is "sensed" by the JJFET 200 at the gate 215 can alter the critical current and cause the JJFET 200 to transition between the superconducting state and the conducting state. The resulting voltage pulse output from the JJFET 200 may then be measured.

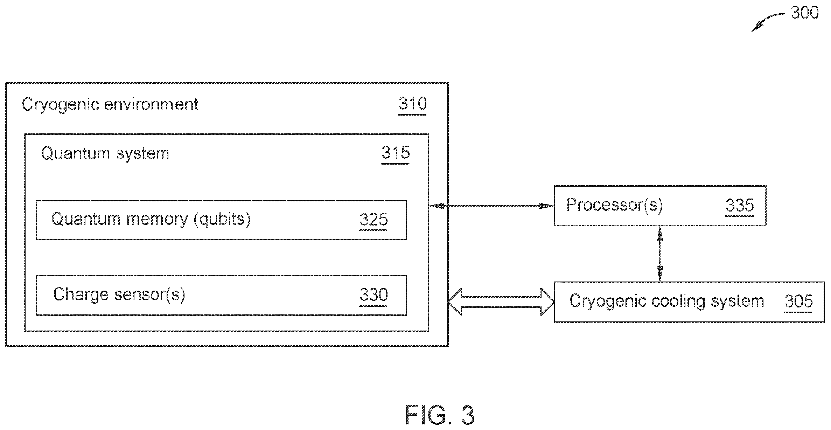

Figure 3 depicts a system 300 having one or more charge sensors 330 in a quantum-scale device or system 315, according to one or more aspects. The system 300 may be used in conjunction with any other aspects described herein. For example, the one or more charge sensors 330 of the system 300 may include one or more JJs 100 (Figure 1) and/or one or more JJFETs 200 (Figure 2).

The system 300 comprises a cryogenic cooling system 305 in fluid communication with a cryogenic environment 310 for the quantum system 315. Typically, the cryogenic environment 310 is defined as having a temperature of 120 K (-153 °C) or less. In some aspects, the cryogenic environment 310 has a temperature that is very close to absolute zero (0 K; -273.15 °C) as superconductivity and the associated quantum characteristics are most pronounced at these temperatures. However, the cryogenic environment 310 may have any alternate suitable temperature to ensure superconductivity (e.g., based on the critical temperature of the superconductor material(s)). The cryogenic cooling system 305 may have any suitable implementation, as would be known to a person of ordinary skill in the art. In some aspects, the cryogenic cooling system 305 uses liquefied gases such as liquid nitrogen, liquid hydrogen, or liquid helium to achieve the desired temperature within the cryogenic environment 310.

The quantum system 315 comprises a quantum memory 325 that may have any suitable implementation, as would be known to a person of ordinary skill in the art. In some aspects, the quantum memory 325 comprises a plurality of Josephson junctions that operate as a plurality of superconducting qubits. In some aspects, quantum information in the qubits may be stored, changed, and/or read by transmitting microwave photons at the qubits. Other implementations of the quantum memory 325 are also contemplated.

In some aspects, the quantum memory 325 stores quantum information in the plurality of qubits that each in a state of superposition (representing the combination of all possible configurations). Some or all of the plurality of qubits may further exhibit quantum entanglement, where changes occurring to one qubit also affect one or more entangled qubits. Thus, the plurality of qubits may be used to represent complex, multidimensional computation spaces.

Alternate implementations of the quantum system 315 are also contemplated. For example, the quantum system 315 may include one or more quantum processors, one or more quantum networks, one or more quantum sensors, or one or more classical (that is, non-quantum) cryosensors.

In some aspects, the quantum system 315 is communicatively coupled with one or more processors 335 that are separate from the quantum system 315. The one or more processors 335 may be disposed inside or outside the cryogenic environment 310. The one or more processors 335 may have any suitable implementation of classical (that is, non-quantum) processor(s). In some aspects, the one or more processors 335 comprise control circuitry that communicates control signals and/or data with the one or more quantum processors 320. For example, the control signals may be used to control characteristics of the microwave photons used to interact with the qubits of the quantum memory 325, and the one or more processors 335 may receive measurement data from the one or more quantum processors 320. In some aspects, the one or more processors 335 are communicatively coupled with the cryogenic cooling system 305, and further communicate control signals and/or data with the cryogenic cooling system 305 to maintain the cryogenic environment 310. In some aspects, the one or more processors 335 are communicatively coupled with one or more external networks and operate as a gateway to communicate with public and/or private networks (e.g., the cloud). In one non-limiting example, the quantum system 315 may be included in a quantum repeater spanning a substantial distance.

The quantum system 315 further comprises one or more charge sensors 330 that are operable to detect changes in charge in one or more charge islands of the quantum system 315. In some aspects, each of the one or more charge islands comprises a respective one or more quantum dots. Each quantum dot is a semiconductor structure (e.g., Si or GaAs) of sufficiently small size to exhibit quantum mechanical properties, e.g., the semiconductor structure can trap individual electrons. Described another way, each quantum dot operates as an "artificial atom." Although described in terms of quantum dot(s), other implementations of the one or more charge islands are also contemplated. For example, the one or more charge islands may alternately comprise one or more material defects, one or more grain boundaries, or one or more micro surface features, and so forth.

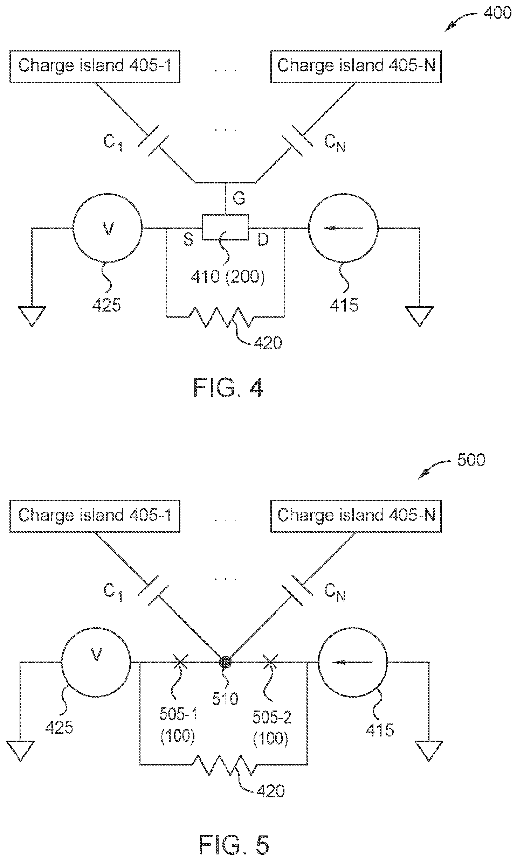

In some aspects, each of the one or more charge sensors 330 includes one or more JJs 100 (Figure 1) and/or one or more JJFETs 200 (Figure 2). As discussed above, applying different values of electrostatic potential near a JJ alters its quantum tunneling characteristics. In some aspects, the JJs included in the one or more charge sensors 330 (whether implemented as JJs 100 or JJFETs 200) are capacitively coupled with the one or more charge islands according to selected configurations, some examples of which are illustrated in Figures 4 and 5.

By capacitively coupling the one or more charge islands to the JJs in any of the selected configurations, changes to electron occupancy occurring in the one or more charge islands will cause the critical currents of the JJs to vary. In some aspects, a bias current (e.g., a DC current) is supplied to the JJs that is less than a first value of the critical current. The first value of the critical current corresponds to a first charge state of the one or more charge islands. When a predefined change in charge occurs to the one or more charge islands (e.g., the electron occupancy of the one or more charge islands meets a predefined count), the change in charge reduces the critical current to a second value that is less than the bias current. Thus, the JJs transition between the superconducting state and the conducting state, and present a resistance causing a pulse in an output voltage of the JJs. The pulse in the output voltage may then be measured, allowing a single-shot readout of the quantum system 315.

Beneficially, use of the JJs enable a rapid, single-shot readout method for measuring the charge occupancy in the quantum system 315. As devices and systems reduce in size to atomic scales, the ability to rapidly measure charge states inside these systems will free resources and accelerate operations that utilize these systems. Further, the JJs used in the one or more charge sensors 330 (whether implemented as the JJs 100 or the JJFETs 200) operate natively in the cryogenic environment 310 hosting the quantum system 315, providing a more efficient utilization of the infrastructure required for the cryogenic environment 310.

Figure 4 depicts an exemplary apparatus 400 having one or more charge islands 405-1, ..., 405-N capacitively coupled to a JJFET 410, according to one or more aspects. The apparatus 400 may be used in conjunction with any other aspects described herein. For example, the apparatus 400 may represent an exemplary implementation of the charge sensor 330 of Figure 3.

The apparatus 400 comprises the JJFET 410 representing one example of the JJFET 200. The apparatus 400 further comprises one or more charge islands 405-1, ..., 405-N capacitively coupled to a gate (G) of the JJFET 410. In some aspects, each of the one or more charge islands 405-1, ..., 405-N comprises a respective one or more quantum dots. In some aspects, and as shown, the one or more charge islands 405-1, ..., 405-N comprises a plurality of charge islands each coupled to the gate through a respective capacitor $C_1$, ..., $C_N$. Although two charge islands are illustrated, any other number of charge islands are contemplated (e.g., three, four, five or more).

The capacitors $C_1$, ..., $C_N$ may be implemented as discrete elements in the apparatus 400 or may represent capacitances existing between the one or more charge islands 405-1, ..., 405-N, extending across a dielectric region, and the gates of the JJFETs 410 (e.g., due to fabrication processes and relative proximity). The capacitors $C_1$, ..., $C_N$ may have any capacitance values that are suitable for detecting changes in charge occurring at the one or more charge islands 405-1, ..., 405-N. In some aspects, not forming part of the claimed invention, the capacitors $C_1$, ..., $C_N$ have a same capacitance value (e.g., the effects of each charge island 405-1, ..., 405-N are weighted similarly). In the claimed invention, some or all of the capacitors $C_1, ..., C_N$ have different capacitance values. By weighting the effects of each charge island 405-1, ..., 405-N differently, additional information may be communicated to measurement circuitry 425. In one non-limiting example, the capacitors $C_1, ..., C_N$ may have capacitance values that sequentially increase by powers of 2, and the sum of the currents flowing through the capacitors $C_1, ..., C_N$ to the gate effectively identify which one(s) of the charge islands 405-1, ..., 405-N experienced changes in charge. Other encoding schemes are also contemplated, which may include implementing the charge islands 405-1, ..., 405-N with different characteristics.

The apparatus 400 further comprises a current source 415 that is coupled with one of a source (S) or a drain (D) of the JJFET 410. As shown, the current source 415 is connected to the drain of the JJFET 410. The current source 415 may have any suitable implementation, such as a MOSFET constant-current source. The current source 415 supplies a bias current (e.g., a DC current) through the JJFET 410 that is less than a first value of a critical current of the JJFET 410. The first value of the critical current corresponds to a first charge state of the one or more charge islands 405-1, ..., 405-N.

The critical current $I_c$ of the JJFET 410 is related to carrier density and velocity according to the following:

$$I_C = \frac{4\pi V_0 W}{h} \sqrt{\frac{2e}{\pi} C_g (V_g - V_t)}$$

where $W$ is the device width, $C_g$ is the gate capacitance per area, $V_t$ is a threshold voltage $V_g$ is the voltage applied to the gate.

According to the equation for the Resistive Capacitively-Shunted Junction (RCSJ) model for the JJFET 410:

$$V_{DS} = R_N \sqrt{I_{DS}^2 - I_C^2} \qquad I_{DS} > I_C;$$

and

$$V_{DS} = 0 \qquad I_{DS} < I_C.$$

This indicates that a pulse in the output voltage will occur when the persistent current through the JJFET 410 (e.g., the bias current supplied by the current source 415) is greater than the critical current $I_c$.

Thus, in some aspects, a predefined change in charge to the one of more charge islands 405-1, ..., 405-N (e.g., resulting in a second charge state) reduces the critical current of the JJFET 410 to a second value that is less than the bias current. In this way, the JJFET 410 transitions between the superconducting state and the conducting state.

The measurement circuitry 425 is coupled with the other of the source and the drain of the JJFET 410. Stated another way, the current source 415 and the measurement circuitry 425 are arranged on opposite sides of the JJFET 410. As shown, the measurement circuitry 425 is connected to the source of the JJFET 410 and measures an output voltage of the JJFET 410. Because the JJFET 410 transitions to the conducting state when the critical current is reduced below the bias current, the JJFET 410 presents resistive losses and a pulse occurs in the output voltage.

The measurement circuitry 425 may have any suitable implementation, as would be known to the person of ordinary skill in the art. In some aspects, the measurement circuitry 425 comprises amplifier circuitry to amplify the output voltage of the JJFET 410. In some aspects, the measurement circuitry 425 communicates signals to the one or more processors 335 of Figure 3.

The apparatus 400 further comprises a shunt resistor 420 that is coupled between the source and the drain of the JJFET 410. The shunt resistor 420 operates to update the critical current of the JJFET 410 responsive to a change in charge state of the one or more charge islands 405-1, ..., 405-N. In some aspects, the shunt resistor 420 has a smaller resistance than the JJFET 410 presents while in the conducting phase, as this tends to provide a non-hysteretic, overdamped voltage response. In some aspects, the current source 415 is controlled to vary the bias current based on the updated critical current. For example, the one or more processors 335 may communicate a control signal setting the bias current based on a determined charge state of the one or more charge islands 405-1, ..., 405-N. In some aspects, the apparatus 400 may reset a charge state of the one or more charge islands 405-1, ..., 405-N, and the apparatus 400 restores the critical current to the first value using the shunt resistor 420.

Thus, the JJFET 410 may be used in conjunction with the one or more charge islands 405-1, ..., 405-N in the apparatus 400 to provide high-speed, accurate measurements of the localized charge state of the quantum system 315. In some aspects, the apparatus 400 is capable of obtaining single-shot measurements on the order of nanoseconds.

Figure 5 depicts an exemplary apparatus 500 having one or more charge islands 405-1, ..., 405-N capacitively coupled to a node 510 between a pair of series-connected Josephson junctions 505-1, 505-2, according to one or more aspects. The apparatus 500 may be used in conjunction with any other aspects described herein. For example, the apparatus 500 may represent an exemplary implementation of the charge sensor 330 of Figure 3.

The apparatus 500 comprises the series-connected Josephson junctions 505-1, 505-2 representing examples of the JJ 100. The apparatus 500 further comprises the one or more charge islands 405-1, ..., 405-N capacitively coupled to the node 510 through the respec-

tive capacitors $C_1, ..., C_N$. Although two charge islands are illustrated, any other number of charge islands are contemplated (e.g., one, three, four, five or more). As above, the capacitors $C_1, ..., C_N$ may be implemented as discrete elements in the apparatus 400 or may represent capacitances existing between the one or more charge islands 405-1, ..., 405-N, extending across a dielectric region, and the node 510 (e.g., due to fabrication processes and relative proximity).

The apparatus 500 further comprises the current source 415 that is coupled with the JJ 505-2 opposite the node 510. The current source 415 supplies a bias current (e.g., a DC current) through the JJs 505-1, 505-2 that is less than a first value of a critical current of the JJs 505-1, 505-2. The first value of the critical current corresponds to a first charge state of the one or more charge islands 405-1, ..., 405-N.

The apparatus 500 further comprises the measurement circuitry 425 that is coupled with the JJ 505-1 opposite the node 510. In some aspects, a predefined change in charge to the one of more charge islands 405-1, ..., 405-N (e.g., resulting in a second charge state) reduces the critical current of the JJs 505-1, 505-2 to a second value that is less than the bias current. In this way, the JJs 505-1, 505-2 transition between the superconducting state and the conducting state. Because the JJs 505-1, 505-2 transition to the conducting state when the critical current is reduced below the bias current, the JJs 505-1, 505-2 presents resistive losses and a pulse occurs in the output voltage of the apparatus 500. The apparatus 500 further comprises the shunt resistor 420 that is coupled across the pair of JJs 505-1, 505-2 and restores the critical current of the JJs 505-1, 505-2 to the first value after the pulse occurs in the output voltage.

Thus, the JJs 505-1, 505-2 may be used in conjunction with the one or more charge islands 405-1, ..., 405-N in the apparatus 500 to provide high-speed, accurate measurements of the localized charge state of the quantum system 315. In some aspects, the apparatus 500 is capable of obtaining single-shot measurements on the order of nanoseconds. Further, using the JJs 505-1, 505-2 with the one or more charge islands 405-1, ..., 405-N provides a significant reduction of fabrication challenges for charge sensing.

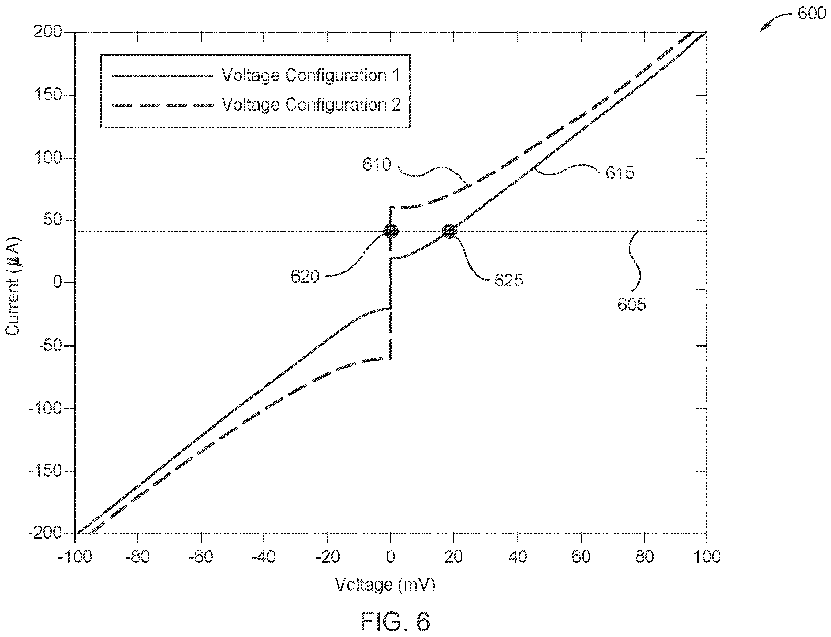

Figure 6 depicts plots of current-voltage (I-V) characteristics of a Josephson junction for different charge states, according to one or more aspects. The features of Figure 6 may be used in conjunction with any other aspects described herein. For example, the plots may describe exemplary operation of the apparatus 400 of Figure 4 or the apparatus 500 of Figure 5.

More specifically, the graph 600 includes a plot 605 representing a bias current supplied by the current source 415. In some aspects, the bias current is less than a first value of the critical current of the JJFET or JJ. As shown, the bias current is approximately 45 microamps (uA). The graph 600 further includes a plot 610 representing I-V characteristics of the JJFET or JJ for a first charge state, and a plot 615 representing I-V characteristics of the JJFET or JJ for a second charge state.

In the plot 610, the JJFET or JJ operates in a superconducting state at the bias current, and the voltage point 620 indicates an output voltage of approximately zero. In the plot 615, the JJFET or JJ operates in a conducting state at the bias current (in other words, the bias current exceeds the critical current), and the voltage point 625 indicates an output voltage of approximately 20 millivolts (mV).

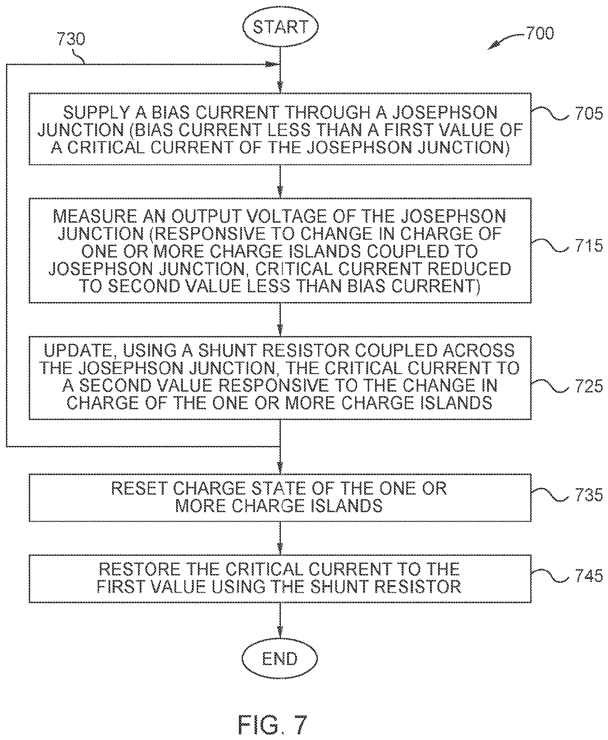

Figure 7 is a method 700 of charge sensing in a quantum system, according to one or more aspects. The method 700 may be used in conjunction with other examples, such as being performed using the apparatus 400 of Figure 4 or apparatus 500 of Figure 5.

The method 700 begins at block 705, where the apparatus supplies a bias current through a Josephson junction, the bias current less than a first value of a critical current of the Josephson junction. In some aspects, the JJ is implemented as a two-terminal device, such as the JJ 100 of Figure 1. In other aspects, the JJ is implemented as a three-terminal device, such as the JJFET 200 of Figure 2.

At block 715, the apparatus measures an output voltage of the Josephson junction. The output voltage measurement is responsive to a change in charge of one of more charge islands coupled to the Josephson junction. In some aspects, the change in charge is determined at a node between series-connected JJs. In other aspects, the change in charge is determined at a gate of the JJFET. The change in charge reduces the critical current to a second value less than the bias current.

At block 725, the apparatus updates, using a shunt resistor coupled across the Josephson junction, the critical current to a second value responsive to the change in charge of the one or more charge islands. In some aspects, the method 700 proceeds along branch 730 and returns to block 705, where the apparatus supplies a bias current that is less than the (updated) critical current. In this way, responsive to the change in charge, the critical current settles at an updated value (due to the shunt resistor) and the apparatus updates the bias current to be less than the updated value.

In some aspects, the method 700 proceeds to block 735, where the apparatus resets a charge state of the one or more charge islands. At block 745, the apparatus restores the critical current to the first value using the shunt resistor. The method 700 ends following completion of block 745.

As will be appreciated by one skilled in the art, aspects described herein may be embodied as a system, method or computer program product. Accordingly, aspects may take the form of an entirely hardware aspect, an entirely software aspect (including firmware, resident software, micro-code, etc.) or an aspect combining software and hardware aspects that may all generally be referred to herein as a "circuit," "module" or "system." Furthermore, aspects described herein may take the form of a computer program product embodied in one or more computer readable storage medium(s) having computer readable program code embodied thereon.

Program code embodied on a computer readable storage medium may be transmitted using any appropriate medium, including but not limited to wireless, wireline, optical fiber cable, **RF,** etc., or any suitable combination of the foregoing.

Computer program code for carrying out operations for aspects of the present disclosure may be written in any combination of one or more programming languages, including an object oriented programming language such as Java, Smalltalk, C++ or the like and conventional procedural programming languages, such as the "C" programming language or similar programming languages. The program code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present disclosure are described herein with reference to flowchart illustrations and/or block diagrams of methods, apparatuses (systems), and computer program products according to aspects of the present disclosure. It will be understood that each block of the flowchart illustrations and/or block diagrams, and combinations of blocks in the flowchart illustrations and/or block diagrams, can be implemented by computer program instructions. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the block(s) of the flowchart illustrations and/or block diagrams.

These computer program instructions may also be stored in a computer readable medium that can direct a computer, other programmable data processing apparatus, or other device to function in a particular manner, such that the instructions stored in the computer readable medium produce an article of manufacture including instructions which implement the function/act specified in the block(s) of the flowchart illustrations and/or block diagrams.

The computer program instructions may also be loaded onto a computer, other programmable data processing apparatus, or other device to cause a series of operational steps to be performed on the computer, other programmable apparatus or other device to produce a computer implemented process such that the instructions which execute on the computer, other programmable data processing apparatus, or other device provide processes for implementing the functions/acts specified in the block(s) of the flowchart illustrations and/or block diagrams.

The flowchart illustrations and block diagrams in the Figures illustrate the architecture, functionality, and operation of possible implementations of systems, methods, and computer program products according to various aspects of the present disclosure. In this regard, each block in the flowchart illustrations or block diagrams may represent a module, segment, or portion of code, which comprises one or more executable instructions for implementing the specified logical function(s). It should also be noted that, in some alternative implementations, the functions noted in the block may occur out of the order noted in the Figures. For example, two blocks shown in succession may, in fact, be executed substantially concurrently, or the blocks may sometimes be executed in the reverse order or out of order, depending upon the functionality involved. It will also be noted that each block of the block diagrams and/or flowchart illustrations, and combinations of blocks in the block diagrams and/or flowchart illustrations, can be implemented by special purpose hardware-based systems that perform the specified functions or acts, or combinations of special purpose hardware and computer instructions.

While the foregoing is directed to aspects of the present disclosure, other and further aspects of the disclosure may be devised without departing from the basic scope thereof, and the scope thereof is determined by the claims that follow.

## Claims

1. A method (700) of charge sensing in a quantum system (315), the method comprising:

   supplying (705) a bias current (605) through a Josephson junction (100, 200, 410, 505-1, 505-2), the bias current less than a first value of a critical current of the Josephson junction; and

   measuring (715) an output voltage of the Josephson junction, wherein responsive to a change in charge of one or more charge islands (405-1, ..., 405-N) of a plurality of charge islands (405-1, ..., 405-N), each coupled to the Josephson junction through a respective capacitor ($C_1$, ..., $C_N$), some or all of the capacitors, corresponding to the plurality of charge islands, having different capacitance values, the critical current is reduced to a second value less than the bias current, causing a voltage drop across the Josephson junction.

2. The method of claim 1, wherein each of the one or more charge islands comprises a respective one or more quantum dots, one or more material defects, one or more grain boundaries, or one or more micro surface features.

3. The method of any of the preceding claims, further comprising:
updating (725), using a shunt resistor (420) coupled across the Josephson junction, the critical current of the Josephson junction to a second value responsive to the change in charge of the one or more charge islands.

4. The method of any of the preceding claims,

wherein the Josephson junction is included in a Josephson junction field-effect transistor (JJFET) (200, 410),
wherein the one or more charge islands are capacitively coupled to a gate (G) of the JJFET, and
wherein the bias current is supplied by a current source (415) coupled to a source (S) or drain (D) of the JJFET.

5. The method of any of the preceding claims,

wherein the Josephson junction is included in a pair of series-connected Josephson junctions (100, 505-1, 505-2),
wherein the one or more charge islands are capacitively coupled between the Josephson junctions of the pair (510), and
wherein the bias current is supplied by a current source (415) coupled with one of the Josephson junctions of the pair.

6. An apparatus (400) comprising:

a Josephson junction field-effect transistor (JJFET) (200, 410);
a plurality of charge islands (405-1, ..., 405-N) each capacitively coupled to a gate (G) of the JJFET through a respective capacitor ($C_1$, ..., $C_N$), some or all of the capacitors, corresponding to the plurality of charge islands, having different capacitance values; and
a current source (415) coupled with one of a source (S) or a drain (D) of the JJFET, the current source to supply a bias current (605) less than a first value of a critical current of the JJFET,
wherein a predefined change in charge to one of more charge islands of the plurality of charge islands reduces the critical current to a second value less than the bias current.

7. The apparatus of claim 6, wherein each of the one or more charge islands comprises a respective one or more quantum dots, one or more material defects, one or more grain boundaries, or one or more micro surface features.

8. The apparatus of claim 6 or 7, further comprising:
a shunt resistor (420) coupled between the source and the drain of the JJFET.

9. The apparatus of any one of claims 6-8, further comprising:
measurement circuitry (425) coupled to the other of the source or the drain of the JJFET.

10. The apparatus of claim 9, wherein the measurement circuitry comprises amplifier circuitry to amplify an output voltage of the JJFET.

11. An apparatus (500) comprising:

a pair of series-connected Josephson junctions (100, 505-1, 505-2);
a plurality of charge islands (405-1, ..., 405-N) each capacitively coupled to a node (510) between the Josephson junctions of the pair through a respective capacitor ($C_1$, ..., $C_N$), some or all of the capacitors, corresponding to the plurality of charge islands, having different capacitance values; and
a current source (415) coupled to a first Josephson junction of the pair, the current source to supply a bias current (605) less than a first value of an effective critical current of the Josephson junctions,
wherein a predefined change in charge to one of more charge islands of the plurality of charge islands reduces the effective critical current to a second value less than the bias current.

12. The apparatus of claim 11, wherein each of the one or more charge islands comprises a respective one or more quantum dots, one or more material defects, one or more grain boundaries, or one or more micro surface features.

13. The apparatus of claim 11 or 12, further comprising:
a shunt resistor (420) coupled across the pair of Josephson junctions.

14. The apparatus of any one of claims 11-13, further comprising:
measurement circuitry (425) coupled to a second Josephson junction of the pair.

15. Use of an apparatus according to any one of claims 6-14 for performing the method of any one of claims 1-5.

**Patentansprüche**

1. Verfahren (700) für Ladungserfassung in einem Quantensystem (315), das Verfahren umfassend:

   Zuführen (705) eines Bias-Stroms (605) durch einen Josephson-Übergang (100, 200, 410, 505-1, 505-2), wobei der Bias-Strom kleiner als ein erster Wert eines kritischen Stroms des Josephson-Übergangs ist; und
   Messen (715) einer Ausgangsspannung des Josephson-Übergangs, wobei als Reaktion auf eine Ladungsänderung einer oder mehrerer Ladungsinseln (405-1, ..., 405-N) einer Vielzahl von Ladungsinseln (405-1, ..., 405-N), die jede durch einen jeweiligen Kondensator ($C_1$, ..., $C_N$) mit dem Josephson-Übergang gekoppelt sind, wobei einige oder alle Kondensatoren, die der Vielzahl von Ladungsinseln entsprechen, unterschiedliche Kapazitätswerte aufweisen, der kritische Strom auf einen zweiten Wert, der kleiner als der Bias-Strom ist, reduziert wird, was zu einem Spannungsabfall über dem Josephson-Übergang hinweg führt.

2. Verfahren nach Anspruch 1, wobei jede der einen oder der mehreren Ladungsinseln einen jeweiligen einen oder mehrere Quantenpunkte, einen oder mehrere Materialdefekte, eine oder mehrere Korngrenzen oder ein oder mehrere Mikrooberflächenmerkmale umfasst.

3. Verfahren nach einem der vorstehenden Ansprüche, ferner umfassend:
   Aktualisieren (725), unter Verwendung eines Shunt-Widerstands (420), gekoppelt über den Josephson-Übergang hinweg, des kritischen Stroms des Josephson-Übergangs auf einen zweiten Wert als Reaktion auf die Ladungsänderung der einen oder der mehreren Ladungsinseln.

4. Verfahren nach einem der vorstehenden Ansprüche,

   wobei der Josephson-Übergang in einem Josephson-Übergang-Feldeffekttransistor (JJFET) (200, 410) eingeschlossen ist,
   wobei die eine oder die mehreren Ladungsinseln mit einem Gate (G) des JJFET kapazitiv gekoppelt sind, und
   wobei der Bias-Strom durch eine Stromquelle (415), die mit einer Source (S) oder einem Drain (D) des JJFET gekoppelt ist, zugeführt wird.

5. Verfahren nach einem der vorstehenden Ansprüche,

   wobei der Josephson-Übergang in einem Paar in Reihe geschalteter Josephson-Übergänge (100, 505-1, 505-2) eingeschlossen ist,

   wobei die eine oder die mehreren Ladungsinseln zwischen den Josephson-Übergängen des Paars (510) kapazitiv gekoppelt sind, und
   wobei der Bias-Strom durch eine Stromquelle (415), die mit einem der Josephson-Übergänge des Paars gekoppelt ist, zugeführt wird.

6. Einrichtung (400), umfassend:

   einen Josephson-Übergang-Feldeffekttransistor (JJFET) (200, 410);
   eine Vielzahl von Ladungsinseln (405-1, ..., 405-N), die jede durch einen jeweiligen Kondensator ($C_1$, ..., $C_N$) mit einem Gate (G) des JJFET kapazitiv gekoppelt sind, wobei einige oder alle der Kondensatoren, die der Vielzahl von Ladungsinseln entsprechen, unterschiedliche Kapazitätswerte aufweisen; und
   eine Stromquelle (415), die mit einem von einer Source (S) oder einem Drain (D) des JJFET gekoppelt ist, wobei die Stromquelle einen Bias-Strom (605), der kleiner als ein erster Wert eines kritischen Stroms des JJFET ist, zuführen soll,
   wobei eine vordefinierte Ladungsänderung auf einer von mehreren Ladungsinseln der Vielzahl von Ladungsinseln den kritischen Strom auf einen zweiten Wert, der kleiner als der Bias-Strom ist, reduziert.

7. Einrichtung nach Anspruch 6, wobei jede der einen oder der mehreren Ladungsinseln einen jeweiligen einen oder mehrere Quantenpunkte, einen oder mehrere Materialdefekte, eine oder mehrere Korngrenzen oder ein oder mehrere Mikrooberflächenmerkmale umfasst.

8. Einrichtung nach Anspruch 6 oder 7, ferner umfassend:
   einen Shunt-Widerstand (420), der zwischen der Source und dem Drain des JJFET gekoppelt ist.

9. Einrichtung nach einem der Ansprüche 6 bis 8, ferner umfassend:
   eine Messschaltung (425), die mit dem anderen von der Source oder dem Drain des JJFET gekoppelt ist.

10. Einrichtung nach Anspruch 9, wobei die Messschaltung eine Verstärkerschaltung, um eine Ausgangsspannung des JJFET zu verstärken, umfasst.

11. Einrichtung (500), umfassend:

    ein Paar in Reihe geschalteter Josephson-Übergänge (100, 505-1, 505-2);
    eine Vielzahl von Ladungsinseln (405-1, ..., 405-N), die jede durch einen jeweiligen Kondensator ($C_1$, ..., $C_N$) mit einem Knoten (510) zwischen den Josephson-Übergängen des Paars kapazitiv gekoppelt sind, wobei einige oder alle der Kondensatoren, die der Vielzahl von Ladungsinseln entsprechen, unterschiedliche Kapazitätswerte aufweisen; und

eine Stromquelle (415), die mit einem ersten Josephson-Übergang des Paars gekoppelt ist, wobei die Stromquelle einen Bias-Strom (605), der kleiner als ein erster Wert eines effektiven kritischen Stroms der Josephson-Übergänge ist, zuführen soll,

wobei eine vordefinierte Ladungsänderung auf einer von mehreren Ladungsinseln der Vielzahl von Ladungsinseln den effektiven kritischen Strom auf einen zweiten Wert, der kleiner als der Bias-Strom ist, reduziert.

**12.** Einrichtung nach Anspruch 11, wobei jede der einen oder der mehreren Ladungsinseln einen jeweiligen einen oder mehrere Quantenpunkte, einen oder mehrere Materialdefekte, eine oder mehrere Korngrenzen oder ein oder mehrere Mikrooberflächenmerkmale umfasst.

**13.** Einrichtung nach Anspruch 11 oder 12, ferner umfassend:
einen Shunt-Widerstand (420), der über das Paar Josephson-Übergänge hinweg gekoppelt ist.

**14.** Einrichtung nach einem der Ansprüche 11 bis 13, ferner umfassend:
die Messschaltung (425), die mit einem zweiten Josephson-Übergang des Paars gekoppelt ist.

**15.** Verwendung einer Einrichtung nach einem der Ansprüche 6 bis 14 zum Durchführen des Verfahrens nach einem der Ansprüche 1 bis 5.

**Revendications**

**1.** Procédé (700) de détection de charge dans un système quantique (315), le procédé comprenant :

la fourniture (705) d'un courant de polarisation (605) à travers une jonction Josephson (100, 200, 410, 505-1, 505-2), le courant de polarisation étant inférieur à une première valeur d'un courant critique de la jonction Josephson ; et
la mesure (715) d'une tension de sortie de la jonction Josephson, dans lequel en réponse à un changement de charge d'un ou de plusieurs îlots de charge (405-1, ..., 405-N) d'une pluralité d'îlots de charge (405-1, ..., 405-N), chacun couplé à la jonction Josephson par l'intermédiaire d'un condensateur respectif ($C_1$, ..., $C_N$), certains ou tous les condensateurs, correspondant à la pluralité d'îlots de charge, ayant des valeurs de capacité différentes, le courant critique est réduit à une seconde valeur inférieure au courant de polarisation, ce qui provoque une chute de tension aux bornes de la jonction Josephson.

**2.** Procédé selon la revendication 1, dans lequel chacun des un ou plusieurs îlots de charge comprend un ou plusieurs points quantiques respectifs, un ou plusieurs défauts de matériau respectifs, un ou plusieurs joints de grain respectifs ou une ou plusieurs caractéristiques de microsurface respectives.

**3.** Procédé selon l'une quelconque des revendications précédentes, comprenant en outre :
la mise à jour (725), à l'aide d'une résistance shunt (420) couplée aux bornes de la jonction Josephson, du courant critique de la jonction Josephson vers une seconde valeur sensible au changement de charge des un ou plusieurs îlots de charge.

**4.** Procédé selon l'une quelconque des revendications précédentes,

dans lequel la jonction Josephson est incluse dans un transistor à effet de champ à jonction Josephson (JJFET) (200, 410),
dans lequel les un ou plusieurs îlots de charge sont couplés capacitivement à une grille (G) du JJFET, et
dans lequel le courant de polarisation est fourni par une source de courant (415) couplée à une source (S) ou à un drain (D) du JJFET.

**5.** Procédé selon l'une quelconque des revendications précédentes,

dans lequel la jonction Josephson est incluse dans une paire de jonctions Josephson connectées en série (100, 505-1, 505-2),
dans lequel les un ou plusieurs îlots de charge sont couplés capacitivement entre les jonctions Josephson de la paire (510), et
dans lequel le courant de polarisation est fourni par une source de courant (415) couplée à l'une des jonctions Josephson de la paire.

**6.** Appareil (400) comprenant :

un transistor à effet de champ à jonction Josephson (JJFET) (200, 410) ;
une pluralité d'îlots de charge (405-1, ..., 405-N), chacun couplé capacitivement à une grille (G) du JJFET par l'intermédiaire d'un condensateur ($C_1$, ..., $C_N$) respectif, certains ou tous les condensateurs, correspondant à la pluralité d'îlots de charge, ayant des valeurs de capacité différentes ; et

une source de courant (415) couplée à l'un d'une source (S) et d'un drain (D) du JJFET, la source de courant fournissant un courant de polarisation (605) inférieur à une première valeur d'un courant critique du JJFET, dans lequel une modification prédéfinie de la charge d'un ou de plusieurs îlots de charge de la pluralité d'îlots de charge réduit le courant critique à une seconde valeur inférieure au courant de polarisation.

7. Appareil selon la revendication 6, dans lequel chacun des un ou plusieurs îlots de charge comprend un ou plusieurs points quantiques respectifs, un ou plusieurs défauts de matériau respectifs, un ou plusieurs joints de grain respectifs ou une ou plusieurs caractéristiques de microsurface respectives.

8. Appareil selon la revendication 6 ou 7, comprenant en outre :
une résistance shunt (420) couplée entre la source et le drain du JJFET.

9. Appareil selon l'une quelconque des revendications 6 à 8, comprenant en outre :
un montage de circuits de mesure (425) couplé à l'autre de la source et du drain du JJFET.

10. Appareil selon la revendication 9, dans lequel le montage de circuits de mesure comprend un montage de circuits d'amplification pour amplifier une tension de sortie du JJFET.

11. Appareil (500) comprenant :

une paire de jonctions Josephson connectées en série (100, 505-1, 505-2) ;
une pluralité d'îlots de charge (405-1, ..., 405-N), chacun couplé capacitivement à un nœud (510) entre les jonctions Josephson de la paire par l'intermédiaire d'un condensateur ($C_1$, ..., $C_N$) respectif, certains ou tous les condensateurs, correspondant à la pluralité d'îlots de charge, ayant des valeurs de capacité différentes ; et
une source de courant (415) couplée à une première jonction Josephson de la paire, la source de courant étant destinée à fournir un courant de polarisation (605) inférieur à une première valeur d'un courant critique effectif des jonctions Josephson,
dans lequel une modification prédéfinie de la charge d'un ou de plusieurs îlots de charge de la pluralité d'îlots de charge réduit le courant critique efficace à une seconde valeur inférieure au courant de polarisation.

12. Appareil selon la revendication 11, dans lequel chacun des un ou plusieurs îlots de charge comprend un ou plusieurs points quantiques respectifs, un ou plusieurs défauts de matériau respectifs, un ou plusieurs joints de grain respectifs ou une ou plusieurs caractéristiques de microsurface respectives.

13. Appareil selon la revendication 11 ou 12, comprenant en outre :
une résistance shunt (420) couplée aux bornes de la paire de jonctions Josephson.

14. Appareil selon l'une quelconque des revendications 11 à 13, comprenant en outre :
un montage de circuits de mesure (425) couplé à une seconde jonction Josephson de la paire.

15. Utilisation d'un appareil selon l'une quelconque des revendications 6 à 14 pour mettre en œuvre le procédé selon l'une quelconque des revendications 1 à 5.

**FIG. 1**

**FIG. 2**

FIG. 3

400

Charge island 405-1 . . . Charge island 405-N

$C_1$ $C_N$

G

V S D

410 (200)

425 415

420

FIG. 4

500

Charge island 405-1 . . . Charge island 405-N

$C_1$ $C_N$

V

425

505-1 510 505-2

(100) (100)

415

420

FIG. 5

FIG. 6

START

730

700

SUPPLY A BIAS CURRENT THROUGH A JOSEPHSON JUNCTION (BIAS CURRENT LESS THAN A FIRST VALUE OF A CRITICAL CURRENT OF THE JOSEPHSON JUNCTION) 705

MEASURE AN OUTPUT VOLTAGE OF THE JOSEPHSON JUNCTION (RESPONSIVE TO CHANGE IN CHARGE OF ONE OR MORE CHARGE ISLANDS COUPLED TO JOSEPHSON JUNCTION, CRITICAL CURRENT REDUCED TO SECOND VALUE LESS THAN BIAS CURRENT) 715

UPDATE, USING A SHUNT RESISTOR COUPLED ACROSS THE JOSEPHSON JUNCTION, THE CRITICAL CURRENT TO A SECOND VALUE RESPONSIVE TO THE CHANGE IN CHARGE OF THE ONE OR MORE CHARGE ISLANDS 725

RESET CHARGE STATE OF THE ONE OR MORE CHARGE ISLANDS 735

RESTORE THE CRITICAL CURRENT TO THE FIRST VALUE USING THE SHUNT RESISTOR 745

END

FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2003173498 A1

- JP 2008076082 A

**Non-patent literature cited in the description**

- Quantum-Limited Electrometer Based on Single Cooper Pair Tunneling. *Physical Review Letters*, 01 June 1996, vol. 76 (23), 4408-4411

- **LOTKHOV S.V.** Superconducting electrometer based on the resistively shunted Bloch transistor. *IEEE Transactions on Applied Superconductivity*, 01 June 1999, vol. 9 (2), 3664-3667